Europäisches Patentamt

European Patent Office

Office européen des brevets

(11) Veröffentlichungsnummer: **0 311 975 B1**

## (12) EUROPÄISCHE PATENTSCHRIFT

(45) Veröffentlichungstag der Patentschrift: **08.07.92**

(21) Anmeldenummer: **88116849.6**

(22) Anmeldetag: **11.10.88**

(51) Int. Cl.⁵: **G21K 1/087**

(54) Vorrichtung zur Reflexion niederenergetischer Ionen.

(30) Priorität: **12.10.87 DE 3734423**

(43) Veröffentlichungstag der Anmeldung:
**19.04.89 Patentblatt 89/16**

(45) Bekanntmachung des Hinweises auf die
Patenterteilung:
**08.07.92 Patentblatt 92/28**

(84) Benannte Vertragsstaaten:
**CH FR GB LI**

(56) Entgegenhaltungen:
**US-A- 2 736 799**
**US-A- 2 953 750**
**US-A- 4 556 794**

**INTERNATIONAL ELECTRON DEVICES, 4.-6.
Dezember 1978, Seiten 264-267, IEEE, New
York, C. ANDERSON et al.: "Electron guides
with extraction, a potentially useful new
class of electron devices"**

**REVIEW OF SCIENTIFIC INSTRUMENTS, Band
58, Nr. 8, August 1987, Seiten 1353-1361, New
York, US; J.H.M. BONNIE et al.:
"Resonance-enhanced multiphoton ionization for diagnosis of a weakly ionized plasma"**

**JOURNAL OF PHYSICS E. SCIENTIFIC IN-
STRUMENTS, Band 16, Nr. 7, Juli 1983, Seiten
636-642, The Institute of Physics, Dorking,
GB; F.H. READ et al.: "A movable electrostatic lens"**

(73) Patentinhaber: **Forschungszentrum Jülich
GmbH
Postfach 1913
W-5170 Jülich(DE)**

(72) Erfinder: **Schelten, Jakob, Dr.
Peter-Stommen-Strasse 10
W-5170 Jülich(DE)**
Erfinder: **Kurz, Ulrich
Meyburginsel 11
W-5170 Jülich(DE)**

# Beschreibung

Die Erfindung bezieht sich auf eine Vorrichtung zur Reflexion niederenergetischer Ionen.

Es ist Aufgabe der Erfindung, eine Vorrichtung zu schaffen, mittels der niederenergetische Ionen reflektiert werden können. Dabei soll es möglich sein, durch weiteren Ausbau dieser Vorrichtung ein Strahlungsführungssystem für Ionenstrahlung (Ionenleiter) als auch einen Ionenspiegel zu schaffen.

Die der Erfindung zugrundeliegende Aufgabe wird gemäß der Erfindung durch längliche, mit möglichst geringem Abstand mit ihrer Längsseite parallel zueinander angeordneten Elektroden gelöst, von denen jeweils benachbarte an ein elektrisches Potential entgegengesetzten Vorzeichens angelegt sind. Der Abstand der Elektroden soll dabei zwar möglichst gering, dabei aber auch so bemessen sein, daß zwischen den Elektroden kein elektrischer Durchschlag erfolgt.

Die Reflexion der Ionen erfolgt an der Randzone der erfindungsgemäßen Elektrodenanordnung, die sich in dem die Ionen enthaltenden Vakuumsystem befindet.

Eine vorteilhafte Weiterausgestaltung der Vorrichtung gemäß der Erfindung besteht darin, daß die Elektroden derart ausgebildet sind, daß sie einen den Ionenstrahl seitlich umfassenden Ionenleiter bilden. Die Elektroden können dabei als Ringe ausgebildet sein, aber beispielsweise auch aus elektrisch voneinander isolierten Teilstücken von Ringen bestehen, die zusammen den Ionenstrahl umfassen.

Bei einer Ausführungsvariante des Ionenleiters weisen die Elektroden die Form eines rechteckigen Rahmens auf, so daß auch der Querschnitt des so gebildeten Ionenleiters rechteckig ist. Bei einer weiteren Ausführungsform sind die Elektroden in Form einer mehrgängigen Schraube, beispielsweise in der Form einer Doppelhelix, ausgebildet.

Der erfindungsgemäße Ionenleiter als Strahlführungssystem für Ionen ist vergleichbar mit dem Lichtleiter, der aus zwei Materialien mit unterschiedlichen Brechungsindexes besteht und bei dem die Lichtstrahlen an den Grenzflächen reflektiert werden, falls der Glanzwinkel der Lichtstrahlen kleiner als der Glanzwinkel für Totalreflexion ist. Dieser bekannte Lichtleiter wird für den breitbandigen, verlustarmen Transport von Licht, für die flexible Lichtzuführung, für Verteilung von Licht einer Quelle an mehrere Stellen, bei der Signalübertragung und anderes mehr eingesetzt. Auch beim Ionenleiter gemäß der Erfindung erfolgt die Reflexion der Strahlen in einer randnahen Zone, falls der Glanzwinkel der Ionenstrahlen kleiner als ein kritischer Grenzwinkel ist. Auch der Ionenleiter kann für den breitbandigen, verlustarmen Transport von Ionenstrahlen eingesetzt werden.

Die elektrische Feldstärke, die am Rande des Ionenleiters am höchsten ist, klingt exponentiell mit der charakteristischen 1/e-Länge

$$x_{1/e} = \lambda/(2\,\pi)$$

ab, wobei

$\lambda/2$: der Abstand zweier benachbarter Elektroden ist.

Die Ablenkung der Ionenstrahlen an der Vorrichtung gemäß der Erfindung ist eine Reflexion mit der Eigenschaft, daß Einfallswinkel gleich Ausfallswinkel ist, wenn der Glanzwinkel $\alpha$ des Ionenstrahls kleiner ist als ein kritischer Maximalwinkel $\alpha_c$. Dieser beträgt

$$\alpha_c = g\,\tfrac{1}{2}\,\tfrac{\Delta V}{U}\,.$$

Dabei ist

g ein Geometriefaktor, der vom Verhältnis zwischen Breite b der Lücken zwischen den Elektroden und dem doppelten Abstand (dem Periodenabstand $\lambda$) zwischen zwei Elektroden abhängt. Für g gilt in erster Näherung

$$g \approx 0.7$$

Ferner ist

$\pm\,\Delta V$: das an den Elektroden anliegende Potential

U: die elektrische Spannung in [Volt], mit der die kinetische Energie eU der Ionen angegeben wird (e: Elementarladung).

Der Grenzwinkel $\alpha_c$ für Reflexion hängt nicht von der Periodenlänge $\lambda$ ab.

Die Eigenschaft der Reflexion mit Einfallsgleich Ausfallswinkel ist unabhängig von der Energie der Ionen, d. h. die Ablenkung ist nicht dispersiv. Bei der Festlegung des Ionenleiters ist allerdings die maximale Feldstärke zu berücksichtigen. Sie wird durch das an den Elektroden anliegende entgegengesetzte Potential $\pm\,\Delta V$ und durch den Periodenabstand festgelegt und zwar nach der Beziehung

$$E_{max} \simeq 10\,\tfrac{\Delta V}{\lambda}$$

Bei gekrümmten Ionenleitern ist zu beachten, daß der Krümmungsradius R der Beziehung

$$R \geq \frac{2\,D}{\left(\tfrac{1}{2}\,g\,\dfrac{\Delta V}{U}\right)^2}$$

genügt, wobei

R:　　Krümmungsradius des Ionenleiters [mm]

D:　　kleinster Durchmesser des Ionenleiters [mm]

± Δ V:　an den Elektroden anliegendes elektrisches Potential [Volt]

U:　　die elektrische Spannung [Volt], mit der die kinetische Energie eU der Ionen angegeben wird (e: Elementarladung)

sind.

Ionenleiter gemäß der Erfindung sind einsetzbar für Ionen niedriger Energie und Ionenstrahlen eines relativ großen Durchmessers. Für das Verhältnis beider Größen gibt es eine obere, technisch bedingte Grenze, die bei

$$\frac{U}{D} \leq 0.1 \text{ kV/mm}$$

liegt und letztlich von der Durchschlagsfeldstärke festgelegt wird.

Ionenleiter gemäß der Erfindung können eingesetzt werden in Apparaturen zur Bestrahlung von großen Flächen, für das Ionenmischen (Aufdampfen von Schichten unter Ionenbeschuß) und für das reaktive Ionenstrahlätzen, wobei Ionen von weniger als 1 KeV von der Ionenquelle zum Substrat geführt werden.

Eine weitere Ausführungsart der Vorrichtung gemäß der Erfindung besteht darin, daß die Elektroden zur Bildung eines planaren oder gekrümmten Ionen-Spiegels flächig nebeneinanderliegend ausgebildet sind. Ein solcher Spiegel ermöglicht die dispersionsfreie Reflexion von Ionenstrahlen.

Die Vorrichtung gemäß der Erfindung und Ausführungsarten hiervon sind in der Zeichnung schematisch dargestellt und werden im folgenden näher erläutert.

Es zeigen

Figur 1　　einen Längsschnitt durch einen geraden Ionenleiter

Figur 2　　einen Querschnitt durch den Ionenleiter gemäß Figur 1, längs der Linie A/A′

Figur 3　　einen Längsschnitt durch einen gekrümmten Ionenleiter

Figur 4　　einen geraden Ionenleiter mit Elektroden in Form einer Doppelhelix

Figur 5　　einen Längsschnitt durch einen Ionenspiegel

Figur 6　　einen Querschnitt durch den Ionenspiegel gemäß Figur 5, längs der Linie A/A′

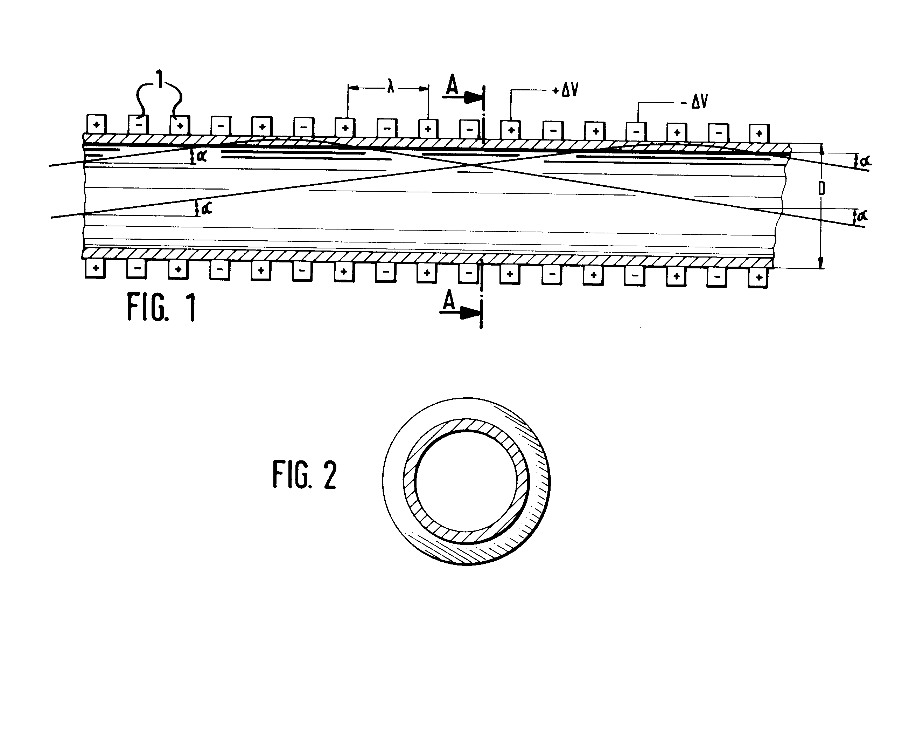

Der in den Figuren 1 und 2 dargestellte Ionenleiter besteht aus ringförmigen, parallel zueinander angeordneten Elektroden 1, deren Periodenabstand λ unter Berücksichtigung der angelegten Potentiale möglichst gering gewählt ist. An die Elektroden sind elektrische Potentiale ± Δ V mit jeweils entgegengesetztem Vorzeichen angelegt. Der Durchmesser des Ionenleiters beträgt D. Die charakteristische 1/e-Länge der Randzone, in der die Ionen, die unter dem Winkel α in den Ionenleiter eintreten, reflektiert werden, ist schraffiert dargestellt. Sie beträgt $\frac{\lambda}{2\pi}$.

Wie aus der Zeichnung zu entnehmen ist, ist der Einfallswinkel gleich dem Ausfallswinkel.

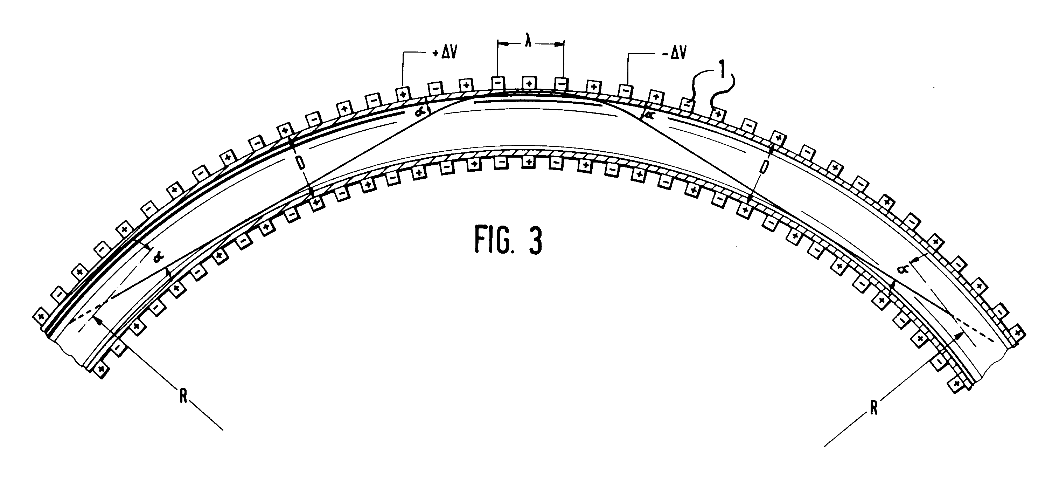

Die Darstellung des gekrümmten Ionenleiters in Figur 3 zeigt den Lauf eines Ionenstrahls mit dem Winkel zur Mittelachse des Ionenleiters. Der Radius des gekrümmten Ionenleiters ist R. Die Randzone ist wieder schraffiert dargestellt. Der Querschnitt des Ionenleiters ist ringförmig. Sein kleinster Durchmesser ist D.

Werden beispielsweise 10 KeV Ionen an den Elektroden, an denen ein Potential von ± 10 kV angelegt ist, reflektiert, so ist der Grenzwinkel $\alpha_c$ = 0.35 radian. Bei einem Periodenabstand von λ = 20 mm beträgt die Dicke der Randzone 3 mm und die maximale Feldstärke 5 kV/mm. Bei einem Ionen-Leiter-Durchmesser von 100 mm darf der Leiter einen Krümmungsradius von R = 1.6 m haben.

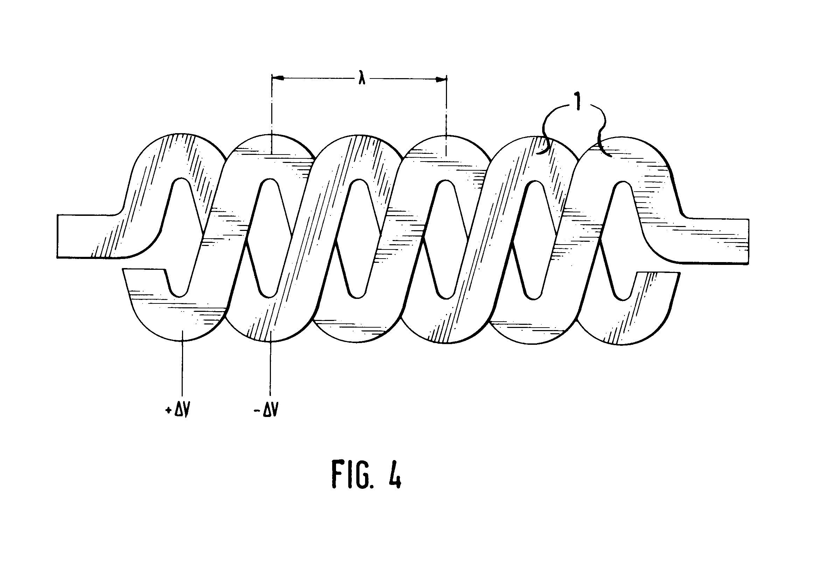

In Figur 4 ist ein Ionenleiter in Doppelhelix-Form schematisch dargestellt.

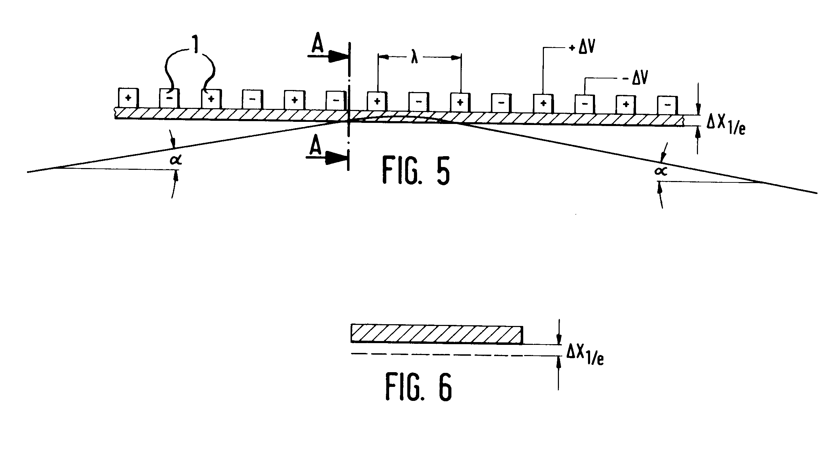

Die Darstellung des Ionenspiegels in Figur 5 zeigt ebenfalls einen reflektierten Ionenstrahl mit gleichem Einfalls- und Ausfallswinkel. Der Ionenstrahl wird in der Spiegelschicht der Dicke $\frac{\lambda}{2\pi}$ dispersionsfrei reflektiert.

Figur 6 zeigt einen Längsschnitt durch den Ionenspiegel.

**Patentansprüche**

1.　Vorrichtung zur Reflexion von niederenergetischen Ionen,
　　**gekennzeichnet durch**
　　längliche, mit möglichst geringem Abstand mit ihrer Längsseite parallel zueinander angeordnete Elektroden (1), von denen jeweils benachbarte an ein elektrisches Potential (± Δ V) entgegengesetzten Vorzeichens angelegt sind.

2.　Vorrichtung nach Anspruch 1,
　　**dadurch gekennzeichnet,**
　　daß die Elektroden (1) derart ausgebildet sind, daß sie einen den Ionenstrahl seitlich umfassenden Ionenleiter bilden.

3.　Vorrichtung nach Anspruch 2,
　　**dadurch gekennzeichnet,**
　　daß die Elektroden (1) als Ringe ausgebildet sind.

4. Vorrichtung nach Anspruch 2,
**dadurch gekennzeichnet,**
daß die Elektroden (1) die Form eines rechtekkigen Rahmens aufweisen.

5. Vorrichtung nach Anspruch 2,
**dadurch gekennzeichnet,**
daß die Elektroden (1) in Form einer mehrgängigen Schraube, beispielsweise in der Form einer Doppelhelix, ausgebildet sind.

6. Vorrichtung nach einem der Ansprüche 2 bis 5,
**dadurch gekennzeichnet,**
daß bei gekrümmtem Ionen-Leiter der Krümmungsradius R der Beziehung

$$R \geq \frac{2 \ D}{\left(\frac{1}{2}g \ \frac{\Delta \ V}{U}\right) \ 2}$$

genügt, wobei
R: Krümmungsradius des Ionen-Leiters [mm]
D: kleinster Durchmesser des Ionen-Leiters [mm]
± Δ V: an den Elektroden anliegendes elektrisches Potential [Volt]
U: die elektrische Spannung [Volt], mit der die kinetische Energie eU der Ionen angegeben wird (e: Elementarladung)
sind.

7. Vorrichtung nach Anpsruch 1,
**dadurch gekennzeichnet,**
daß die Elektroden (1) zur Bildung eines planaren oder gekrümmten Ionen-Spiegels flächig nebeneinanderliegend ausgebildet sind.

## Claims

1. Device for reflecting low-energy ions, characterised by elongated electrodes (1), which are arranged at the smallest possible spacing with their longitudinal sides parallel to one another and of which neighbouring ones are respectively connected to an electric potential (± Δ V) of opposite sign.

2. Device according to Claim 1, characterised in that the electrodes (1) are constructed in such a way that they form an ion conductor laterally surrounding the ion beam.

3. Device according to Claim 2, characterised in that the electrodes (1) are constructed as rings.

4. Device according to Claim 2, characterised in that the electrodes (1) have the form of a rectangular frame.

5. Device according to Claim 2, characterised in that the electrodes (1) are constructed in the form of a multi-thread screw, for example in the form of a double helix.

6. Device according to one of Claims 2 to 5, characterised in that in the case of a curved ion conductor the radius of curvature R satisfies the relationship

$$R \geq \frac{2 \ D}{\left(\frac{1}{2}g \ \frac{\Delta \ V}{U}\right) \ 2}$$

where
R is the radius of curvature of the ion conductor [mm],
D is the smallest diameter of the ion conductor [mm],
± Δ V is the electric potential [volts] present at the electrodes, and
U is the electric voltage [volts] with which the kinetic energy eU of the ions is specified (e being the elementary charge).

7. Device according to Claim 1, characterised in that the electrodes (1) are constructed adjacent to one another in two dimensions in order to form a planar or curved ion mirror.

## Revendications

1. Dispositif de réflexion d'ions de basse énergie, caractérisé,
par des électrodes (1) oblongues, disposées parallèlement les unes aux autres par leurs côtés longitudinaux, à une distance aussi petite que possible, les électrodes voisines étant portées à un potentiel électrique (± Δ V) de polarités opposées.

2. Dispositif suivant la revendication 1, caractérisé,
en ce que les électrodes (1) sont constituées de manière à former un conducteur d'ions entourant latéralement le faisceau d'ions.

**3.** Dispositif suivant la revendication 2,
caractérisé,
en ce que les électrodes (1) sont constituées en anneaux.

**4.** Dispositif suivant la revendication 2,
caractérisé,
en ce que les électrodes (1) présentent la forme d'un cadre rectangulaire.

**5.** Dispositif suivant la revendication 2,
caractérisé,
en ce que les électrodes sont constituées sous la forme d'une vis à plusieurs pas, par exemple sous la forme d'une hélice double.

**6.** Dispositif suivant l'une des revendications 2 à 5,
caractérisé,
en ce que, dans le cas d'un conducteur d'ions incurvé, le rayon de courbure R satisfait à la relation

$$R \geq \frac{2\ D}{\left(\frac{1}{2}\ g\ \frac{\Delta\ V}{U}\right)^2}$$

R      étant le rayon de courbure du conducteur d'ions [mm]

D      étant le diamètre le plus petit du conducteur d'ions [mm]

$\pm \Delta V$      étant le potentiel électrique appliqué aux électrodes [volt]

U      étant la tension électrique [volt], avec laquelle l'énergie cinétique eU des ions est donnée (e : charge élémentaire).

**7.** Dispositif suivant la revendication 1,
caractérisé,
en ce que les électrodes (1) sont disposées les unes à côté des autres pour former un miroir d'ions plan ou incurvé.

FIG. 1

FIG. 2

FIG. 3

FIG. 4

FIG. 5

FIG. 6